# EUROPEAN PATENT SPECIFICATION

(11) **EP 0 785 579 B1**
(45) Date of publication and mention of the grant of the patent: **06.10.2004**
(21) Application number: 96922252.0
(22) Date of filing: 05.07.1996
(51) Int. Cl.: H01L 21/3205, H01L 27/108, H01L 21/8242, H01G 4/008

(54) **DIELECTRIC CAPACITOR AND PROCESS FOR PREPARING THE SAME**
FESTDIELEKTRIKUMKONDENSATOR UND VERFAHREN ZU SEINER HERSTELLUNG
CONDENSATEURS DIELECTRIQUES ET LEUR PROCEDE DE FABRICATION

(30) Priority: 07.07.1995 JP 17214295
(43) Date of publication of application: 23.07.1997
(60) Divisional application: 04076904.4
(73) Proprietor: ROHM CO., LTD., Kyoto-shi Kyoto 615 (JP)
(72) Inventor: NAKAMURA, Takashi, Rohm Co., Ltd., Kyoto-shi, Kyoto 615 (JP)
(74) Representative: Beresford, Keith Denis Lewis
(86) International application number: PCT/JP1996/001883
(87) International publication number: WO 1997/003468

(56) References cited:
- EP-A- 0 409 018
- EP-A- 0 415 750
- EP-A- 0 514 149
- EP-A- 0 609 081
- EP-A- 0 689 249
- JP-A- 7 169 854
- JP-A- 8 008 403
- JP-A- 8 008 407
- JP-A- 8 162 619
- US-A- 5 142 437
- US-A- 5 164 808
- VIJAY D P ET AL: "ELECTRODES FOR PBZRXTI1-XO3 FERROELECTRIC THIN FILMS" JOURNAL OF THE ELECTROCHEMICAL SOCIETY, vol. 140, no. 9, 1 September 1993, pages 2640-2645, XP000424120
- LEE J -G ET AL: "DEPOSITION AND PROPERTIES OF REACTIVELY SPUTTERED RUTHENIUM DIOXIDETHIN FILMS AS AN ELECTRODE FOR FERROELECTRIC CAPACITORS" JAPANESE JOURNAL OF APPLIED PHYSICS, vol. 33, no. 12B, PART 01, 1 December 1994, pages 7080-7085, XP000624355

## Description

The present invention relates to a capacitor, more specifically, improvement of ferroelectricity of the dielectric medium, or its permittivity and other characteristics of the capacitor.

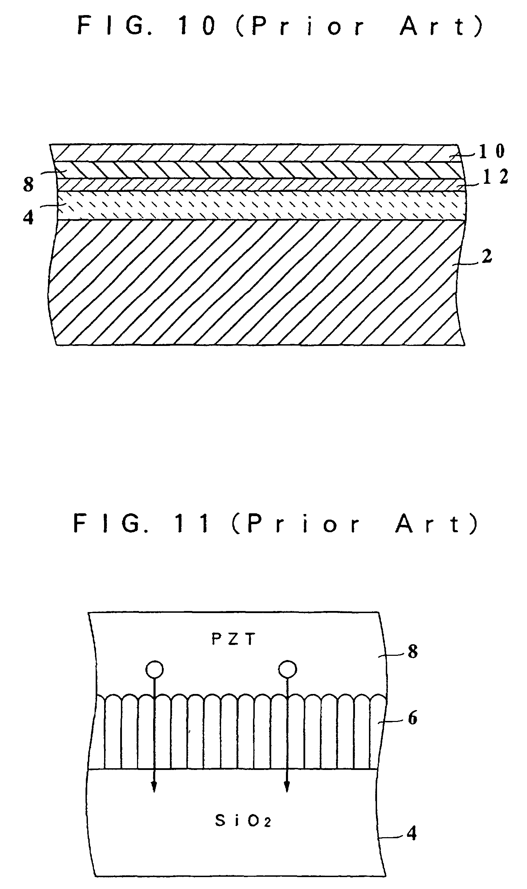

Fig. 10 shows a conventional ferroelectric capacitor. A silicon oxide layer 4 is formed on a silicon substrate 2. A lower electrode 6 of platinum is provided thereon. A PZT (PbZrₓ Ti₁₋ₓ 0₃) film 8 as a ferroelectric oxide layer is formed on the lower electrode 6, and an upper electrode 10 of platinum is provided thereon. Thus, the ferroelectric capacitor is formed by the lower electrode 6, the PZT film 8 and the upper electrode 10.

The reason for using platinum for the lower electrode 6 is as follows. The PZT film 8 must be formed on a layer which is oriented. This is because the ferroelectricity of PZT is degraded if the PZT film is formed on an amorphous layer because it cannot be oriented. Also, the lower electrode 6 must be insulated from the silicon substrate 2. Accordingly, a silicon oxide layer 4 is formed on the silicon substrate 2. The silicon oxide layer 4 is amorphous. In general, although a layer formed on an amorphous material becomes non-orientable, a layer of platinum has a characteristic of becoming oriented even when it is formed on amorphous material. Accordingly, platinum is used for forming the lower electrode because of the reason described above.

However, the conventional ferroelectric capacitor has the following problem still to be resolved.

The problem is degradation of ferroelectricity caused by frequent inversion of polarisation, aging and loss of oxygen from the ferroelectric oxide material (PZT), since platinum has a tendency of allowing oxygen and Pb to pass through it. In other words, there is a high probability of loss of oxygen contained in the ferroelectric oxide material (and also Pb in case of PZT) between columnar crystals of platinum shown in Fig. 11.

The problem of degradation of permittivity arises in a capacitor using a dielectric material having a high dielectric constant due to the same cause.

It is an aim of the present invention to provide a ferroelectric capacitor having less degradation of ferroelectricity caused by frequent inversion of polarisation and aging or a dielectric capacitor maintaining high dielectric constant, both of which resolve the problem described above.

The term "capacitor" as used herein refers to a structure having electrodes on each side of an insulator, regardless of whether or not it is used for electric charge storage.

United States Patent US-A-5164808 also has addressed the problem of aging in the case of a capacitor comprising a PLZT ferroelectric oxide layer as dielectric layer which is in contact with a lower electrode of Pt. It is suggested therein that such aging is the result of induced fatigue caused by charge trapped at the diode-like junction of the Pt/PLZT interface. To solve this problem the surface of the Pt lower electrode is oxidised and the PLZT is formed on the PtO₂ surface layer. The PtO₂ is said to act as a buffer/passivation layer creating a fully conductive inert oxide interface.

European Patent Application EP-A-0409018 also has addressed the problem of aging in the case of electrical ceramic oxide material devices such as ferroelectric capacitors. This is attributed to the progressive formation of an interfacial oxide layer at the electrical lead material interface. To solve this problem a barrier layer of metal selected from ruthenium, iridium, osmium or rhodium or of a metal oxide thereof is provided between the dielectric layer and the electrical lead. In a preferred embodiment both metal and metal oxide are provided with the metal disposed between the electrical lead and the metal oxide.

European Patent Application EP-A-0415750 concerns thin-film capacitors, particularly capacitors incorporating a dielectric having a dielectric constant of high value of e.g. 100 to 10,000 typically. Examples are ferroelectric dielectric oxides such as the perovskite oxides BaTiO₃, SrTiO₃ and PbZrO₃, and the ilmenite oxides such as LiNBO₃ and Bi₄Ti₃O₁₂. Suggested materials for the lower electrode include ruthenium, ruthenium oxide, rhenium, rhenium oxide, osmium, osmium oxide, iridium and iridium oxide.

Each of the above mentioned documents: US-A-5164808; EP-A-0409018; and EP-A-0415750, disclose a capacitor having those features set out in the preamble of claim 1 attached.

The capacitor defined in claim 1 attached: comprises: as set out in the preamble thereof,
a lower electrode,
a dielectric layer composed of either a ferroelectric oxide material or a dielectric material having a high dielectric constant, formed on the lower electrode said ferroelectric or dielectric material being degradable by loss of oxygen, and
an upper electrode formed on said dielectric layer,
wherein said lower electrode comprises a metal oxide layer, which is selected from IrO₂, PtO₂, Gr PdOₓ.

The metal oxide layer serves to prevent loss of oxygen from the dielectric layer as well as suppressing degradation of ferroelectricity or permittivity caused by aging.

In accordance with the present invention, the lower electrode comprises also a metal layer of one of the metals Ir, Pt, Ru, Re, Pd, or Os; the metal layer is formed on the oxide layer, and the dielectric layer is formed on the metal layer and in mutual contact with the metal layer.

The lower electrode may be formed on a silicon oxide layer located on a substrate. A contact layer may be interposed between the silicon oxide layer and the lower electrode.

The upper electrode also may comprise a metal oxide layer which is selected from: IrO₂, PtO₂, RuOx, ReOx, PdOx or OsOx.

Thus, both of the upper electrode and the lower electrode may have a metal oxide layer.

Therefore, it is possible to prevent loss of oxygen from the dielectric layer as well as suppressing degradation of ferroelectricity or peratittivity caused by aging.

Accordingly, a capacitor which offers excellent ferroelectricity or high-dielectric property can be provided.

Background examples and preferred embodiments of the present invention will now be described with reference to the accompanying drawings, in which:
Fig. 1 is a view showing the structure of a ferroelectric capacitor as a first background example;
Fig. 2 is a diagram showing a nonvolatile memory using a ferroelectric capacitor 22;
Figs. 3A, Fig. 3B, Fig. 3C and Fig. 3D are illustrative drawings showing stages in a manufacturing process of the ferroelectric capacitor of Fig. 1;
Fig. 4 is a view showing the structure of the ferroelectric capacitor when a contact layer 30 is provided;
Fig. 5 is a view showing the structure of the capacitor when a dielectric oxide layer 90 having a high dielectric constant is provided in place of the ferroelectric layer.
Fig. 6 is a view showing the structure of a ferroelectric capacitor as another background example;
Fig. 7 is a view to show how a palladium oxide layer prevents leakage of oxygen from a ferroelectric film;
Fig. 8A, Fig. 8B, Fig. 8C and Fig. 8D are illustrative drawings showing the stages of a manufacturing process for the ferroelectric capacitor shown in Fig. 1;
Figs. 9A & 9B are views showing successive stages in a manufacturing process wherein oxidation of palladium is performed after forming a thin platinum layer;
Fig. 10 is a view showing the structure of a known ferroelectric capacitor; and
Fig. 11 is a view showing leakage of oxygen through a lower electrode 6 of platinum.

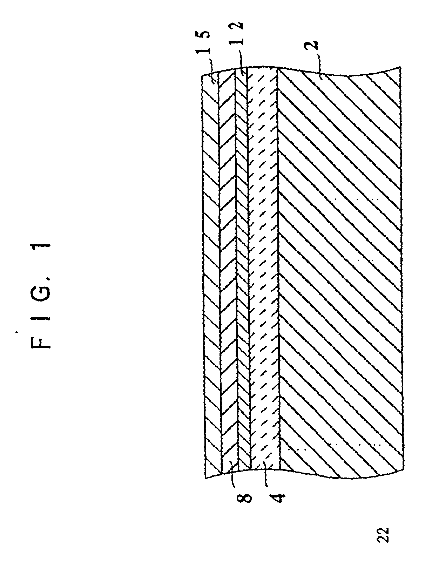

Fig. 1 shows the structure of a ferroelectric capacitor as a background example. In the ferroelectric capacitor 22, a silicon oxide layer 4, a lower electrode 12, a ferroelectric film (ferroelectric oxide layer) 8 and an upper electrode 15 are formed on a silicon substrate 2. The lower electrode 12 is of palladium oxide (PdOx), and the upper electrode 15 is also of palladium oxide (PdOx).

As shown in Fig. 11 which illustrates a conventional ferroelectric capacitor, oxygen contained in the ferroelectric film 8 passes through a platinum layer having columnar crystals. Palladium oxide is used for the lower electrode 12 in this example. Since the palladium oxide layer 12 does not have columnar crystals, it is hard for oxygen to pass through it. Consequently, loss of oxygen from the ferroelectric film 8 can be prevented. Depletion of oxygen can also be prevented by using as the upper electrode 15 one which does not have columnar crystals. Thus, the ferroelectricity of the ferroelectric film 8 is improved. A remarkable reduction of ferroelectricity degradation caused by remanent polarisation Pr is observed when either of the upper electrode 15 or the lower electrode 12 is of palladium oxide in comparison with when either one of the electrodes is of platinum.

Since both of the lower electrode 12 and the upper electrode 15 are of palladium oxide in the example described above, the electrodes of palladium oxide ensure prevention of loss of oxygen and, in case of a ferroelectric film containing Pb, of Pb. Certain prevention of loss can be expected when either of the electrodes is of palladium oxide.

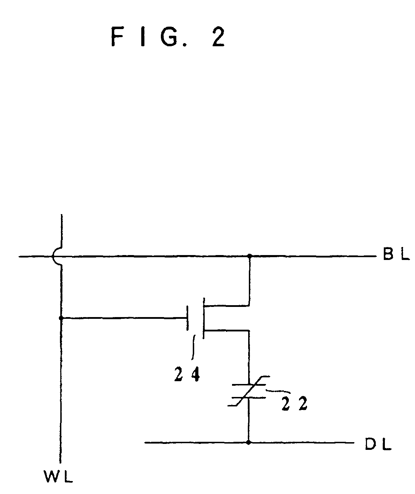

The ferroelectric capacitor 22 described above can be used for a nonvolatile memory when it is combined with a transistor 24 as shown in Fig. 2.

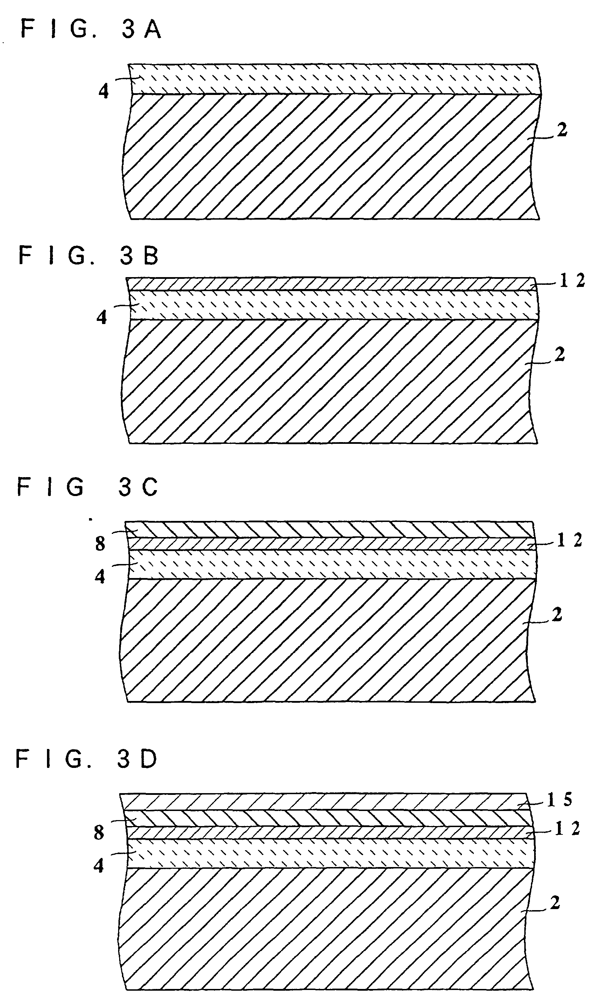

Figs. 3A to 3D show successive stages in a manufacturing process of the ferroelectric capacitor of Fig. 1. A silicon oxide layer 4 is formed by carrying out thermal oxidation of the surface of a silicon substrate 2 (Fig. 3A). In this example, the silicon oxide layer 4 is formed to a thickness of 600 nm. A palladium oxide layer formed on the silicon oxide layer 4 by reactive sputtering using palladium as a target is defined as the lower electrode 12 (Fig. 3B). The lower electrode 12 is formed to a thickness of 200 nm.

A PZT film is formed on the lower electrode 12 as the ferroelectric film 8 by the sol-gel method (Fig. 3C). A mixed solution of Pb(CH₃COO)₂·3H₂O, Zr(t-OC₄H₉)₄ and Ti (i-OC₃H₇)₄ is used as a starter. The mixed solution is dried at a temperature of 150°C after carrying out spin coating, then pre-baking is carried out at a temperature of 400°C for 30 seconds in a dried air atmosphere. Thermal treatment at a temperature of over 700°C is carried out in an O₂ atmosphere after carrying out the process steps described above 5 times. Thus, the ferroelectric film 8 having a thickness of 250 nm is formed. In this example, the PZT film is formed at a value of x equal to 0.52 in PbZr ₓ Ti ₁₋ₓ O₃ (hereinafter the material is indicated as PZT (52 · 48)).

Further, a layer of palladium oxide is formed on the ferroelectric film as the upper electrode 15 by reactive sputtering (Fig. 3D). The upper electrode 15 is formed to a thickness of 200 nm.

Any one of the metallic oxides: IrO₂; PtO₂; ReOx; RuOx; or OsOx; can be used in place of the palladium oxide of the upper electrode.

However, in the case of forming a layer of a ferroelectric material on an oxide layer, orientation of the ferroelectric material is degraded. In order to maintain orientation, the layer of the ferroelectric material is, in accordance with the present invention, formed on a conductive layer formed of any one of the following metals: Ir; Pt; Ru; Re; Pd; or Os. Further, leakage of the ferroelectric material also can be decreased by providing this choice of conductive layer.

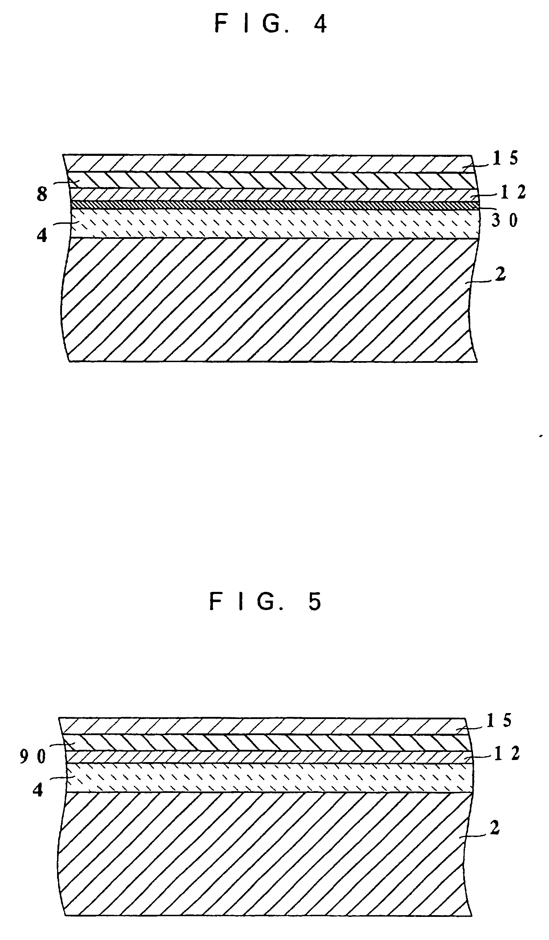

Fig. 4 shows the structure of another ferroelectric capacitor. In this background example, a layer 30 of titanium (having a thickness of 5 nm) is provided as a contact layer 30 between the lower electrode 12 and a silicon oxide layer 4. In general, palladium oxide and silicon oxide do not contact tightly with each other. So that there is a probability to cause degradation of ferroelectricity caused by partial delamination of a layer consisting of a mixed oxide of palladium oxide and silicon oxide. To resolve the degradation, a titanium layer 30 which can be contacted with the silicon oxide layer 4 tightly is provided. Accordingly, the ferroelectricity is improved. The titanium layer can be formed by sputtering.

Although a titanium layer is used as the contact layer 30 in the above example, any other material which improves contact can be utilised. For instance, a layer of platinum can be used as the contact layer.

Although PZT film is used as the ferroelectric film 8 in the examples described above, other ferroelectric oxide materials can be utilised instead. For instance, Bi₄ Ti₃O₁₂ can be used for the ferroelectric film.

Fig. 5 shows the structure of another capacitor. A dielectric layer 90 having a high dielectric constant is used instead of the ferroelectric film 8 in this background example. The lower electrode 12 of palladium oxide is provided on the silicon oxide layer 4, and a high dielectric thin film, of e.g. SrTiO₃, or (Sr, Ba)TiO₃, having a perovskite structure is formed thereon as the dielectric layer 90. In this example, permittivity is maintained in the same manner that ferroelectricity is maintained in the example using a ferroelectric oxide material. In other words, it is clarified that the advantages offered when using the ferroelectric layer can also be obtained when using a dielectric layer having a high dielectric constant.

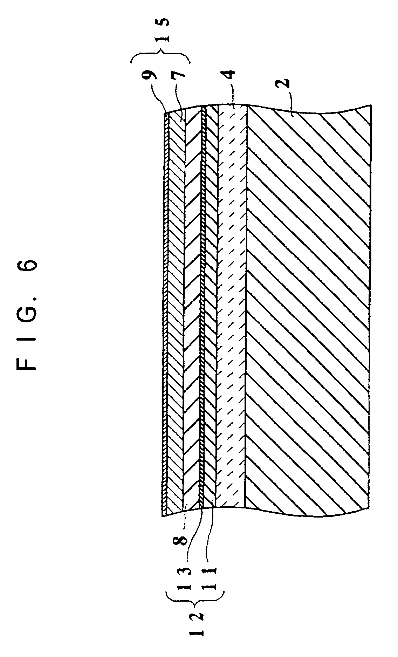

Fig. 6 shows the structure of yet another ferroelectric capacitor. In this background example, the silicon oxide layer 4, the lower electrode 12, the ferroelectric film (ferroelectric layer) 8 and the upper electrode 15 are provided on a silicon substrate 2. The lower electrode 12 consists of a palladium layer 11 and a palladium oxide layer 13. Also, the upper electrode 15 consists of a palladium layer 7 and a palladium oxide layer 9.

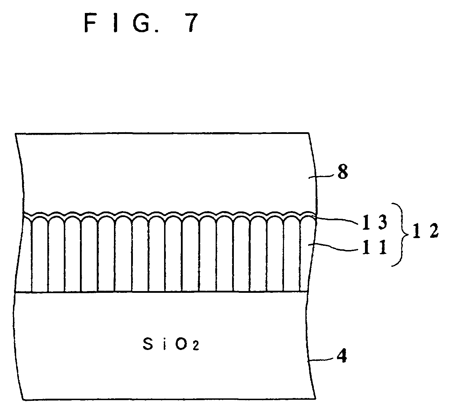

Fig. 7 is an enlarged view of the vicinity of the lower electrode 12. Since the palladium layer 11 has columnar crystals, the oxygen contained in the ferroelectric film 8 passes through the palladium layer 11. A palladium oxide layer 13 is formed on the upper surface of the palladium layer 11 in this example. It is thus possible to prevent loss of oxygen contained in the ferroelectric film 8 by forming the palladium oxide layer 13 as described. The upper electrode 15 obtains the same advantage which the lower electrode 12 offers as described above.

Since, both of the palladium oxide layers are formed in the lower electrode 12 and the upper electrode 15 respectively in this example, it is possible to obtain a ferroelectric capacitor having an excellent ferroelectricity as well as suffering less influence of aging. The certain advantage described above can be achieved when either of the lower electrode 12 or the upper electrode 15 is formed by the structure described above.

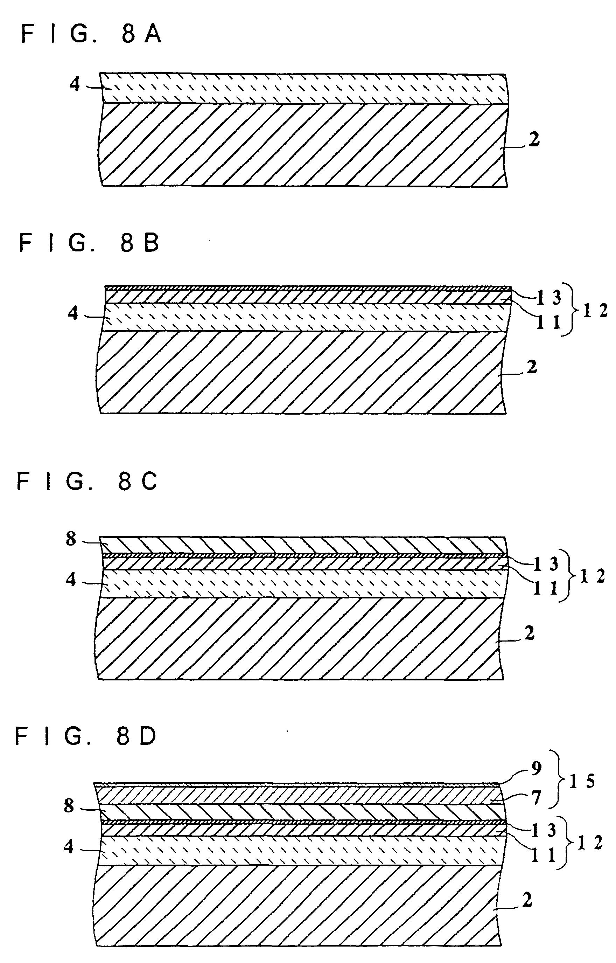

Figs. 8A to 8D show successive stages in a manufacturing process of the ferroelectric capacitor described above. The silicon oxide layer 4 is formed by carrying out thermal oxidation of a surface of the silicon substrate 2 (Fig. 8A). In this exemple, the silicon oxide layer 4 is formed to a thickness of 600 nm. The palladium layer 11 is formed on the silicon oxide layer 4 by utilising palladium as a target (Fig. 8B), The palladium oxide layer 13 is formed by carrying out a thermal treatment at a temperature of 800°C for one minute in an O₂ atmosphere. The palladium layer 11 and the palladium oxide layer 13 thus formed are defined as the lower electrode 12. The lower electrode 12 is formed to a thickness of 200 nm.

A PZT film is formed on the lower electrode 12 as the ferroelectric film 8 by the sol-gel method (Fig. 8C). A mixed solution of Pb(CH₃COO)₂·3H₂ O, Zr(t-OC₄H₉)₄ and Ti(i-OC₃h₇)₄ is used as a starter. The mixed solution is dried at a temperature of 150 °C (hereinafter indicated in celsius) after carrying out spin coating, then pre-baking is carried out at a temperature of 400 °C for 30 seconds in a dried air atmosphere. Thermal treatment at a temperature over 700°C is carried out in a O₂ atmosphere after carrying out the process steps described above for 5 times. Thus, the ferroelectric film 8 having a thickness of 250 nm is formed. In this example, the PZT film is formed at a value of x equal to 0.52 in PbZr ₓ Ti₁₋ₓ O₃ (hereinafter the material is indicated as PZT (52 · 48)).

Further, the palladium layer 7 is formed on the ferroelectric film 8 by sputtering. Then, the palladium oxide layer 9 is formed on a surface of the palladium layer 7 by carrying out a thermal treatment at a temperature of 800°C for one minute in an O₂ atmosphere (Fig. 8D). The palladium layer 7 and the palladium oxide layer 9 thus formed are defined as the upper electrode 15. The upper electrode 15 is formed to a thickness of 200 nm. Thus, the ferroelectric capacitor is completed.

It is also preferable to form the contact layer 30 in the ferroelectric capacitor as described with respect to Fig. 4.

The process step of oxidising the surface of the palladium described above can be applied not only for the ferroelectric film, but also for the dielectric layer having high dielectric constant described above. Accordingly, the same advantages can be expected.

As described above, though loss of oxygen can be prevented by oxidising the surface of the palladium layer, orientation of the ferroelectric layer is degraded by formation of the palladium oxide on its surface. This problem is resolved by providing a conductive layer on the palladium oxide layer 13, which conductive layer is of a metal selected from any of W; Ti; Ta; Ir; Pt; Ru; Re; or Os, as already has been mentioned. The problem can also be resolved by forming the lower electrode as described below.

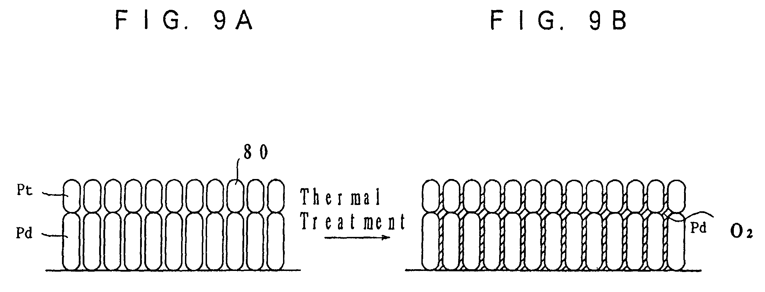

At first, a platinum layer 80 (thin film conductive substance) is formed very thinly on a palladium layer 11 as shown in Fig. 9. The platinum layer 80 is formed to a thickness of 30 nm. Thereafter, a thermal treatment is carried out. The platinum layer is not oxidised because the platinum layer 80 exposed on the surface does not readily react with oxygen. Also, depletion of oxygen is blocked by formation of palladium oxide between crystals of the palladium layer 11 located under the platinum layer 80 as a result of oxidisation of the crystals, because the platinum layer 80 is formed thinly. So that, a lower electrode 12 can be formed which can prevent loss of oxygen while still maintaining good orientation.

The palladium layer 11 having thereon the thin platinum layer 80 and then being oxidised can also be used as the lower electrode 12 by itself. The palladium layer 11 can be used as a conductive layer having good orientation in the embodiment of improving orientation by providing a conductive layer (a palladium layer, a platinum layer and the like) having good orientation on the palladium layer formed by sputtering.

In the process just described iridium may be substituted for palladium, in which case iridium oxide is formed upon partial oxidation of iridium in the presence of the platinum layer covering.

Also, all of examples described in the above can be applied not only to the ferroelectric capacitor using a ferroelectric oxide film but also to a capacitor using a dielectric layer having a high dielectric constant. Exactly the same advantages offered by applying the present measures to the ferroelectric oxide film can be obtained when the present measures are applied to a dielectric layer having a high dielectric constant.

## Claims

1. A capacitor comprising:
a lower electrode (12),
a dielectric layer (8) composed of either a ferroelectric oxide material or a dielectric material having a high dielectric constant formed on the lower electrode said ferroelectric or dielectric material being degradable by loss of oxygen, and
an upper electrode (15) formed on said dielectric layer,
wherein said lower electrode comprises a metal oxide layer (13), which metal oxide is selected from IrO₂, PtO₂, or PdOₓ;
**characterised in that**:
said lower electrode comprises also a metal layer (80) of one of the metals Ir, Pt, Ru, Re, Pd or Os, wherein said metal layer (80) is formed on said oxide layer (13), and said dielectric layer (8) is formed on said metal layer (80) in mutual contact therewith.

2. A capacitor according to claim 1 wherein said upper electrode (15) comprise a metal oxide lawyer (9), which is selected from IrO₂, PtO₂, RuOx, ReOx, PdOx or OsOx.

3. A capacitor according to claim 2 wherein said upper electrode (15) comprises also a metal layer (7) of one of the metals Ir, Pt, Ru, Re, Pd or Os, which metal is the same metal as the metal of said metal oxide layer, wherein said metal layer (7) of said upper electrode (15) is formed on said dielectric layer (8) and said metal oxide layer (9) of said upper electrode (15) is formed on said metal layer (7) of said upper electrode (15) and is an oxidation product thereof.

4. A capacitor according to any preceding claim wherein said metal layer (80) of said lower electrode (12) is of Pt, and said metal oxide layer (13) is of either IrO₂ or PdOx between crystallites of Ir or Pd respectively.

5. A capacitor according to any preceding claim, wherein the lower electrode (12) is provided on a silicon oxide layer (4) formed at the surface of a substrate (2).

6. A capacitor according to claim 5 including a contact layer (30) interposed between said lower electrode (12) and said silicon oxide layer (4).

7. A capacitor according to claim 6 wherein said metal oxide layer (13) of said lower electrode (12) is of PdOx and said contact layer (30) is of either Ti or Pt.

8. A method of manufacturing a capacitor comprising steps of:
forming on a substrate (2) a lower electrode(12) comprising both a metal oxide layer (13) of metal oxide selected from: IrO₂, PtO₂ or PdOₓ, and a metal layer (13), formed on said metal oxide layer, which metal layer is of metal selected from: Ir, Pt, Ru, Re, Pd or Os;
forming, on and in contact with said metal layer (13), a dielectric layer (8) composed of either a ferroelectric oxide material or a dielectric material having a high dielectric constant, which dielectric material is degradable by loss of oxygen; and
forming, on said dielectric layer (8), an upper electrode (15).

9. A method according to claim 8 wherein
said metal oxide layer (13) of said lower electrode (12) is formed on the substrate by sputtering.

10. A method according to claim 8 wherein the step of forming said lower electrode is performed by:
forming, on a substrate (2), a layer of Ir or Pd metal, forming, on said layer of Ir or Pd metal, a film (80) of Pt metal; and
partially oxidising said layer of Ir or Pd metal in the presence of said film of Pt, to produce said metal oxide layer (13) as oxide between crystallites of said Ir or Pd metal.

11. A method according to any of claims 8 to 10 wherein the substrate (2) is of silicon, and a preparatory step of oxidising the surface of said substrate to form a silicon oxide layer (4) is performed before forming said lower electrode thereon.

12. A method according to claim 11 wherein a contact layer (30) is formed on the oxidised surface of the substrate before forming said lower electrode (12) thereon.

13. A method according to claim 12 wherein said contact layer (30) is a layer of Ti or Pt, and the metal oxide layer (13) is a layer of PdOₓ.

14. A method according to any of claims 8 to 13 wherein the step of forming said upper electrode (15) includes forming a metal oxide layer (9) on said dielectric layer (8), which metal oxide layer (9) is of metal oxide selected from IrO₂, PtO₂, RuOₓ, ReOₓ, PdOₓ or OsOx.

15. A method according to claim 14 wherein the step of forming said upper electrode (15) includes forming a metal layer (7) on said dielectric layer (8), which metal layer is selected from Ir, Pt, Ru, Re, Pd or Os; and forming said metal oxide layer (9) on said metal layer (7) by direct oxidation.

## Patentansprüche

1. Kondensator, umfassend:
eine untere Elektrode (12),
eine dielektrische Schicht(8), zusammengesetzt aus entweder einem ferroelektrischen Oxidmaterial oder einem dielektrischen Material mit hoher Dielektrizitätskonstante, gebildet auf der unteren Elektrode, wobei das ferroelektrische oder dielektrische Material durch Verlust von Sauerstoff degradierbar sind, und
eine obere Elektrode (15), gebildet auf der dielektrischen Schicht,
wobei die untere Elektrode eine Metalloxidschicht (13) hat, welche aus IrO₂, PtO₂ oder PdOₓ ausgewählt ist,
**dadurch gekennzeichnet, daß**:
die untere Elektrode ebenso eine Metallschicht (80) aus einem der Metalle Ir, Pt, Ru, Re, Pd oder Os umfaßt,
wobei die Metallschicht (80) auf der Oxidschicht (13) gebildet ist, und die dielektrische Schicht (8) auf der Metallschicht (80) in beiderseitigem Kontakt damit gebildet ist.

2. Kondensator nach Anspruch 1, wobei die obere Elektrode (15) eine Metalloxidschicht (9) umfaßt, welche aus IrO₂, PtO₂, RuOₓ, ReOₓ, OdOₓ oder OsOₓ ausgewählt wird.

3. Kondensator nach Anspruch 2, wobei die obere Elektrode (15) ebenso eine Metallschicht (7) aus einem der Metalle Ir, Pt, Ru, Re, Pd oder Os umfaßt, wobei das Metall das gleiche Metall ist wie das Metall der Metalloxidschicht,
wobei die Metallschicht (7) der oberen Elektrode (15) auf der dielektrischen Schicht (8) gebildet wird und die Metalloxidschicht (9) der oberen Elektrode auf der Metallschicht (7) der unteren Elektrode (15) gebildet wird und ein Oxidationsprodukt hiervon ist.

4. Kondensator nach einem der vorangehenden Ansprüche, wobei die Metallschicht (80) der unteren Elektrode (12) aus Pt besteht, und die Metalloxidschicht (13) entweder aus IrO₂ oder PdOₓ zwischen den jeweiligen Kristalliten von Ir oder Pd besteht.

5. Kondensator nach jedem vorangehenden Anspruch, wobei die untere Elektrode (12) auf einer Siliciumoxidschicht aufgebracht wird, die auf der Oberfläche eines Substrats (2) gebildet wurde.

6. Kondensator nach Anspruch 5, der eine Kontaktschicht (30) einschließt, die zwischen die untere Elektrode (12) und die Siliciumoxidschicht (4) eingebracht ist.

7. Kondensator nach Anspruch 6, wobei die Metalloxidschicht (13) der unteren Elektrode (12) aus PdOₓ und die Kontaktschicht (30) entweder aus Ti oder Pt besteht.

8. Verfahren zur Herstellung eines Kondensators, die Schritte umfassend:
Bilden einer unteren Elektrode (12) auf einem Substrat (2), welche sowohl eine Metalloxidschicht (13), welche aus einem der Metalloxide IrO₂, PtO₂ oder PdOₓ ausgewählt wird, als auch eine Metallschicht (13), welche aus einem der Metalle Ir, Pt, Ru, Re, Pd oder Os ausgewählt wird, die auf der Metalloxidschicht gebildet ist, umfaßt,
Bilden einer dielektrischen Schicht (8), die zusammengesetzt ist aus entweder einem ferroelektrischen Oxidmaterial oder einem dielektrischen Material mit hoher Dielektrizitätskonstante, auf und in Kontakt mit der Metallschicht (13), wobei das dielektrische Material durch Verlust von Sauerstoff degradierbar ist, und
Bilden einer oberen Elektrode (15) auf der dielektrischen Schicht (8).

9. Verfahren nach Anspruch 8, wobei die Metalloxidschicht (13) der unteren Elektrode (12) auf dem Substrat durch Sputtern gebildet wird.

10. Verfahren nach Anspruch 8, wobei der Schritt des Bildens der unteren Elektrode durchgeführt wird durch:
Bilden einer Schicht aus Ir- oder Pd-Metall auf einem Substrat (2), wobei auf der Schicht aus Ir- oder Pd-Metall ein Film (80) aus Pt-Metall gebildet wird, und
partielles Oxidieren der Schicht aus Ir- oder Pd-Metall in der Gegenwart des Films aus Pt, um die Metalloxidschicht (13) als Oxid zwischen Kristalliten des Ir- oder Pd-Metalls herzustellen.

11. Verfahren nach einem der Ansprüche 8 bis 10, wobei das Substrat (2) aus Silicium besteht und ein herstellender Schritt des Oxidierens der Oberfläche des Substrats vor dem Bilden der unteren Elektrode darauf durchgeführt wird, um eine Siliciumoxidschicht (4) zu bilden.

12. Verfahren nach Anspruch 11, wobei eine Kontaktschicht (30) auf der oxidierten Oberfläche des Substrats vor dem Bilden der unteren Elektrode (12) darauf gebildet wird.

13. Verfahren nach Anspruch 12, wobei die Kontaktschicht (30) eine Schicht aus Ti oder Pt ist und die Metalloxidschicht (13) eine Schicht aus PdOₓ ist.

14. Verfahren nach einem der Ansprüche 8 bis 13, wobei der Schritt des Bildens der oberen Elektrode (15) Bilden einer Metalloxidschicht (9), welche aus einem der Metalloxide IrO₂, PtO₂, RuOₓ, PdOₓ, oder OsOₓ ausgewählt wird, auf der dielektrischen Schicht (8) einschließt.

15. Verfahren nach Anspruch 14, wobei der Schritt des Bildens der oberen Elektrode (15) Bilden einer Metallschicht (7), welche aus einem der Metalle Ir, Pt, Ru, Re, Pd oder Os ausgewählt wird, auf der dielektrischen Schicht (8) und Bilden der Metalloxidschicht (9) auf der Metallschicht (7) durch direkte Oxidation einschließt.

## Revendications

1. Condensateur comprenant :
une électrode inférieure (12)
une couche diélectrique (8) composée soit d'un matériau d'oxyde ferroélectrique, soit d'un matériau diélectrique ayant une constante diélectrique élevée formée sur l'électrode inférieure, lequel matériau ferroélectrique ou diélectrique étant dégradable par perte d'oxygène ; et
une électrode supérieure (15) formée sur ladite couche diélectrique,
dans lequel ladite électrode inférieure comprend une couche d'oxyde métallique (13), lequel oxyde métallique est choisi parmi IrO₂, PtO₂ et PdOₓ ;
**caractérisé en ce que** :
ladite électrode inférieure comprend également une couche de métal (80) de l'un des métaux Ir, Pt, Ru, Re, Pd ou Os, dans lequel ladite couche de métal (80) est formée sur ladite couche d'oxyde (13), et ladite couche diélectrique (8) est formée sur ladite couche de métal (80) en contact mutuel avec elle.

2. Condensateur selon la revendication 1, dans lequel ladite électrode supérieure (15) comprend une couche d'oxyde métallique (9) qui est choisi parmi IrO₂, PtO₂, RuOx, ReOx, PdOx et OsOx.

3. Condensateur selon la revendication 2, **caractérisé en ce que** ladite électrode supérieure (15) comprend également une couche de métal (7) de l'un des métaux Ir, Pt, Ru, Re, Pd ou Os, lequel métal est le même métal que le métal de ladite couche d'oxyde métallique, dans lequel ladite couche de métal (7) de ladite électrode supérieure (15) est formée sur ladite couche diélectrique (8), et ladite couche d'oxyde métallique (9) de ladite électrode supérieure (15) est formée sur ladite couche de métal (7) de ladite électrode supérieure (15) et est un produit de son oxydation.

4. Condensateur selon l'une quelconque des revendications précédentes, **caractérisé en ce que** ladite couche de métal (80) de ladite électrode inférieure (12) est en Pt, et ladite couche d'oxyde métallique (13) est soit en IrO₂, soit en PdOₓ entre des cristallites de Ir ou Pd, respectivement.

5. Condensateur selon l'une quelconque des revendications précédentes, **caractérisé en ce que** l'électrode inférieure 12) est prévue sur une couche d'oxyde de silicium (4) formée à la surface d'un substrat (2).

6. Condensateur selon la revendication 5, **caractérisé en ce qu'**il comprend une couche de contact (30) interposée entre ladite électrode inférieure (12) et ladite couche d'oxyde de silicium (4).

7. Condensateur selon la revendication 6, **caractérisé en ce que** ladite couche d'oxyde métallique (13) de ladite électrode inférieure (12) est en PdOx et ladite couche de contact (30) est soit en Ti, soit en Pt.

8. Procédé de fabrication d'un condensateur, comprenant les étapes consistant à :
former sur un substrat (2) une électrode inférieure (12) comprenant à la fois une couche d'oxyde métallique (13) d'un oxyde métallique sélectionné parmi : IrO₂, PtO₂ et PdOₓ, et une couche de métal (13), formée sur ladite couche d'oxyde métallique, laquelle couche de métal est en métal sélectionné parmi : Ir, Pt, Ru, Re, Pd et Os ;
former sur et en contact avec ladite couche de métal (13), une couche diélectrique (8) composée soit d'un matériau d'oxyde ferroélectrique, soit d'un matériau diélectrique ayant une constante diélectrique élevée, lequel matériau diélectrique est dégradable par perte d'oxygène ; et
former sur ladite couche diélectrique (8) une électrode supérieure (15).

9. Procédé selon la revendication 8, **caractérisé en ce que** ladite couche d'oxyde métallique (13) de ladite électrode inférieure (12) est formée sur le substrat par pulvérisation.

10. Procédé selon la revendication 8, **caractérisé en ce que** l'étape de formation de ladite électrode inférieure est réalisée :
en formant sur un substrat (2) une couche en métal Ir ou Pd, formant, sur ladite couche en métal Ir ou Pd, un film (80) en métal Pt ; et
en oxydant partiellement ladite couche en métal Ir ou Pd en présence dudit film en Pt, pour produire ladite couche d'oxyde métallique (13) comme oxyde entre les cristallites dudit métal Ir ou Pd.

11. Procédé selon l'une quelconque des revendications 8 à 10, **caractérisé en ce que** le substrat (2) est en silicium, et une étape préparatoire d'oxydation de la surface dudit substrat pour former une couche d'oxyde de silicium est exécutée avant de former ladite électrode inférieure dessus.

12. Procédé selon la revendication 11, **caractérisé en ce qu'**une couche de contact (30) est formée sur la surface oxydée du substrat avant de former ladite électrode inférieure (12) dessus.

13. Procédé selon la revendication 12, **caractérisé en ce que** ladite couche de contact (30) est une couche en Ti ou Pt, et la couche d'oxyde métallique (13) est une couche en PdOₓ.

14. Procédé selon l'une quelconque des revendications 8 à 13, **caractérisé en ce que** l'étape de formation de ladite électrode supérieure (15) comprend la formation d'une couche d'oxyde métallique (9) sur ladite couche diélectrique (8), laquelle couche d'oxyde métallique (9) est en un oxyde métallique sélectionné parmi IrO₂, PtO₂, RuOₓ, ReOₓ, PdOₓ et OsOx.

15. Procédé selon la revendication 14, **caractérisé en ce que** l'étape de formation de ladite électrode supérieure (15) comprend la formation d'une couche de métal (7) sur ladite couche diélectrique (8), laquelle couche de métal est sélectionnée parmi Ir, Pt, Ru, Re, Pd et Os ; et la formation de ladite couche d'oxyde métallique (9) sur ladite couche de métal (7) par oxydation directe.
